**Europäisches Patentamt**

**European Patent Office**

**Office européen des brevets**

(19)

(11) Veröffentlichungsnummer: **0 073 969**
**A2**

(12) # EUROPÄISCHE PATENTANMELDUNG

(21) Anmeldenummer: **82107475.4**

(22) Anmeldetag: **17.08.82**

(51) Int. Cl.³: **G 11 C 11/24**

(30) Priorität: **27.08.81 DE 3133838**

(43) Veröffentlichungstag der Anmeldung:
**16.03.83 Patentblatt 83/11**

(84) Benannte Vertragsstaaten:
**AT BE CH DE FR GB IT LI LU NL SE**

(71) Anmelder: **Müller, Otto**
**Am Guckenbühl 10**
**D-7750 Konstanz 16(DE)**

(72) Erfinder: **Müller, Otto**
**Am Guckenbühl 10**
**D-7750 Konstanz 16(DE)**

(74) Vertreter: **Riebling, Günter Dr.-Ing., Dipl.-Ing.,**
**Ing.grad. et al,**
**Rennerle 10**
**D-8990 Lindau(DE)**

(54) **Verfahren zur Übergabe des Refresh-Signals an einen Halbleiterspeicher und Schaltung zur Ausführung des Verfahrens.**

(57) Die Erfindung betrifft ein Verfahren zur Übergabe des Refresh-Signals an einen, an einem zentralen Rechnerbus mit bestimmter Priorität hinsichtlich der Aufschaltung angeschlossenen Halbleiterspeicher, wobei das Refresh-Signal und ein die zeitliche Übergabe des Refreshsignals bestimmendes Refresh-Wiederholsignal von einer zentralen Rechnereinheit (CPU) erzeugt werden und über den zentralen Rechnerbus mit bestimmter Priorität im Vergleich zu anderen, am Rechnerbus angeschalteten, Aggregaten an den Halbleiterspeicher übergebbar sind. Die Erfindung besteht darin, daß das Refresh-Widerholsignal in ein oder mehrere zeitlich aufeinanderfolgende Teilsignale aufgeteilt ist und die Übergabe des Refreshsignals während der Dauer des ersten Teilsignals mit niedriger Priorität auf den Rechnerbus erfolgt und daß bei nicht möglicher Übergabe des Refreshsignals während der Dauer des ersten Teilsignals dem Refreshsignal eine höhere Priorität zugeordnet wird und daß das Refreshsignal während des Ablaufes des zeitlich hinter dem ersten Teilsignal liegenden, anderen Teilsignal mit höherer Priorität auf den Rechnerbus geschaltet wird.

FIG 1

--------------------------------------------------------

Verfahren zur Übergabe des Refresh-Signals an einen Halbleiterspeicher und Schaltung zur Ausführung des Verfahrens

--------------------------------------------------------

Die Erfindung betrifft ein Verfahren zur Übergabe des Refresh-Signals an einen, an einem zentralen Rechnerbus mit bestimmter Priorität hinsichtlich der Aufschaltung angeschlossenen Halbleiterspeicher, wobei das Refresh-Signal und ein die zeitliche Übergabe des Refresh-signals bestimmendes Refresh-Wiederholsignal von einer zentralen Rechnereinheit (CPU) erzeugt werden und über den zentralen Rechnerbus mit bestimmter Priorität im Vergleich zu anderen, am Rechnerbus angeschalteten, Aggregaten an den Halbleiterspeicher übergebbar sind.

Ein eingangs genanntes Verfahren und eine Schaltung hierfür wird für digitale Rechenanlagen verwendet. Bei diesen Rechenanlagen verwendeten Halbleiter-Speichern ist es notwendig, in genau bestimmten Zyklen (Refresh-Wiederholzyklen) ein Refresh-Signal an den Halbleiter-Speicher zu übergeben, damit dieser seine Information nicht verliert. Entsprechend den Spezifikationen eines Halbleiter-Speichers ist es beispielsweise erforderlich, daß innerhalb einer Zeitdauer von 2 Millisekunden 128 mal ein Refresh-Wiederholsignal erzeugt wird, dieses Refresh-Wiederholsignal hat dann die Dauer von etwa 15 Mikrosekunden.
Im zeitlichen Verlauf dieses Refresh-Wiederholsignals muß mindestens ein Refresh-Signal mit einer Dauer von Ca. 0.3 Mikrosekunden sein, das an den Speicher abgegeben wird, so daß die im Speicher enthaltene Information nicht verlorengeht. In welchem Bereich das Refresh-Signal innerhalb des Ablaufes des Refresh-Wiederholsignals an den Halbleiter-speicher abgegeben wird, ist gleichgültig.

Wichtig ist nur, daß innerhalb eines Refresh-Wiederholsignals mindestens ein Refresh-Signal an den Halbleiterspeicher abgegeben wird. Das Refreshsignal, welches die CPU verläßt und über den Rechnerbus auf den Halbleiterspeicher gegeben wird, startet in diesem unmittelbar einen Refreshzyklus, der aus einer komplexen Abfolge unterschiedlicher Signale besteht.

Bei einer ersten bekannten Ausführungsform wird das Refreshsignal im Halbleiterspeicher intern erzeugt, was naturgemäss mit einem hohen Schaltungsaufwand und mit Schwierigkeiten bei der Takt-Synchronisierung zwischen den anderen Aggregaten des Rechners und diesem Halbleiterspeicher verbunden ist.

Es ist ferner bekannt, daß das Refresh-Wiederholsignal und das im Laufe des Refresh-Wiederholsignales liegende Refreshsignal von der zentralen Recheneinheit (CPU) erzeugt wird, und über den zentralen Rechnerbus an den gleichfalls an den Rechnerbus angeschlossenen Halbleiterspeicher abgegeben wird. Am Rechnerbus sitzen jedoch noch andere Aggregate, die ihre Daten entsprechend den vorgeschalteten Controllern über den Rechnerbus auf die Speicher oder auf die CPU geben wollen. Es entstehen also Prioritäts- und Übergabeprobleme (Kollisionen) bei der Aufschaltung auf den Rechnerbus, wenn die CPU ihr Refresh-Signal an den Speicher geben will und gleichzeitig die externen Geräte ihre Daten ebenfalls über den Rechnerbus aufschalten wollen.

In der Regel ordnet man der CPU die geringste Priorität zu und den Controllern, welche Plattendaten oder Magnetbanddaten auf den Rechnerbus schalten, die höchste Priorität. In der CPU erfolgt nämlich keine Datenverarbeitung derart, daß während der Bearbeitung und bei der Aufschaltung auf den Rechnerbus Daten unwiederbringlich verlorengehen, während dies bei der Übergabe von Magnetband- oder Plattendaten auf den Rechnerbus der Fall ist, sofern die genannten
Aggregate nicht die höchste Priorität besitzen.

Es stellt sich also das Problem, welche Priorität man den
an den Rechnerbus angeschalteten Halbleiterspeichern zuordnet,
um Kollisionen mit den prioritätshöheren Controllern von
externen Massenspeichern zu vermeiden.

Bisher ist man so verfahren, daß man dem Halbleiterspeicher
die höchste Priorität im Datenbus zuordnete, damit dieser
Halbleiterspeicher auf jeden Fall seinen Refresh-Zyklus durchführt, was natürlich mit dem Nachteil verbunden war, daß
während der Belegung des Rechnerbus mit dem Refresh-Signal
die externen Massenspeicher ihre Signale nicht über den
Rechnerbus übertragen konnten, und es daher zu Schwierigkeiten bei der Datenübermittlung, oder sogar zu einem Verlust von Daten kam.

Die Erfindung hat sich die Aufgabe gestellt, ein Verfahren
zur Übergabe des Refresh-Signals auf den Rechnerbus und
eine hiernach arbeitende Schaltung so weiterzubilden, daß
den externen Massenspeichern eine höhere Priorität zugeordnet werden kann, als dem Refresh-Signal, welches von der
CPU generiert und über den Rechnerbus an den Halbleiterspeicher übertragen wird. Zweck der vorliegenden Erfindung
ist also die Verbesserung des Datenflusses der externen
Massenspeicher über den Rechnerbus, ohne, daß dieser Datenfluss durch ein dazwischengeschaltetes Refresh-Signal unterbrochen wird.

Zur Lösung der gestellten Aufgabe ist die Erfindung dadurch gekennzeichnet, daß das Refresh-Wiederholsignal in
ein oder mehrere zeitlich aufeinanderfolgende Teilsignale
aufgeteilt ist und die Übergabe des Refresh-Signals während der Dauer des ersten Teilsignals mit niedriger Priorität auf den Rechnerbus erfolgt und daß bei nicht möglicher Übergabe des Refreshsignals während der Dauer des ersten Teilsignals dem Refreshsignal eine höhere Priorität zugeordnet wird und daß das Refreshsignal während des Ablaufes des zeitlich hinter dem ersten Teilsignal liegenden, anderen Teilsignal mit höherer Priorität auf den Rechnerbus geschaltet wird.

Wesentliches Merkmal der vorliegenden Erfindung ist also eine zeitlich unterschiedliche Prioritätsteuerung des Refresh-Signals.

In einer ersten Ablaufphase (Ablauf des ersten Teilsignals) wird dem Refresh-Signal eine relativ niedrige Priorität zugeordnet, und es wird versucht, das Refresh-Signal mit dieser niedrigen Priorität auf den Rechnerbus aufzuschalten. Sollte der Rechnerbus während des Ablaufs des ersten Teilsignals gerade und zufällig frei sein, dann gelingt die Übertragung des Refresh-Signals von der CPU auf den Halbleiterspeicher und das Problem ist gelöst, denn, wenn eine freie Zeit auf dem Rechnerbus gefunden wird, dann übertragen zu diesem Zeitpunkt auch nicht die externen Massenspeicher ihre Daten auf den Rechnerbus und es kommt zu keinen Aufschalt-Kollisionen zwischen den externen Massenspeichern und der CPU, die ihr Refresh-Signal an den Halbleiterspeicher übermitteln will.

Wird aber während des Ablaufs des ersten Teilsignals kein "Fenster" (dies ist eine zeitliche Lücke) für die CPU zur Übertragung ihres Refresh-Signals auf den Halbleiterspeicher gefunden, dann drängt die Zeit, denn es muß auf jeden Fall innerhalb eines Refresh-Wiederholsignals ein Refresh-Signal über den Rechnerbus an den Halbleiterspeicher übertragen werden. Wenn also während des Ablaufs des ersten Teilsignals kein solches freies Fenster gefunden wurde, dann muß man während des Ablaufes des anderen, zeitlich auf das erste Teilsignal folgende zweiten Teilsignals ein solches Fenster schaffen, um dem Halbleiterspeicher sein Refresh-Signal zu geben.

Man könnte nun der CPU zur Übermittlung des Refresh-Signals die höchste Priorität aller an den Rechnerbus angeschlossenen Aggregate geben, dies hätte den Vorteil, daß während des Ablaufs des zweiten Teilsignals (d.h. also für den Rest des Ablaufes des Refresh-Wiederholsignals) das Refresh-Signal mit Sicherheit über den Rechnerbus an den Halbleiterspeicher übermittelt wird.
Dies hat aber den Nachteil, daß die Controller der externen Massenspeicher Schwierigkeiten bei der Datenübergabe über den Rechnerbus bekommen, was vor allem für den Plattenspeicher aufgrund seiner hohen Datendichte zutrifft.

Erfindungsgemäss wird nun gemäss dem Anspruch 3 dem Refresh-Signal nicht die höchste aller vorkommenden Prioritäten zugeordnet, sondern eine niedrigere Priorität, die auf jeden Fall unter der Priorität der externen Massenspeicher liegt, aber über der Priorität anderer, am Rechnerbus angeschlossener, übriger Aggregate.

Es ist selbstverständlich nicht zwingend vorgeschrieben, daß das Refresh-Wiederholsignal in zwei zeitlich aufeinanderfolgende Teilsignale aufgeteilt wird, wobei die beiden Teilsignale genau gleich groß sind. Dies wird nur aus schaltungstechnischen Gründen gemacht, weil die Aufteilung in zwei gleiche Teilsignale schaltungstechnisch einfach zu lösen ist. Es liegt aber genauso im Rahmen der vorliegenden Erfindung, eine Aufteilung von ein Drittel zu zwei Drittel der Länge des Refresh-Wiederholsignales zu wählen, so daß also in dem ersten Drittel des Refresh-Wiederholsignales eine Aufschaltung des Refresh-Signals mit niedriger Priorität auf den Rechnerbus versucht wird, und wenn kein freies Fenster gefunden wird, während der restlichen zwei Drittel des Refresh-Wiederholsignales eine Aufschaltung mit hoher Priorität des Refresh-Signals auf den Rechnerbus durchgeführt wird.

Eine nach dem Verfahren arbeitende Schaltung sieht zunächst vor, daß die von einem stabilen Quarz-Oszillator abgeleitete Taktfrequenz über entsprechende Zählerstufen heruntergeteilt wird, um ein sich einmal während des Ablaufes des Refresh-Wiederholsignals änderndes Steuersignal zu erhalten. Dieses Steuersignal wird zunächst mit niedriger Priorität auf den Rechnerbus geschaltet. Die Aufschaltung auf den Rechnerbus niedriger Priorität erfolgt dadurch, daß dieses Steuersignal am Eingang eines UND-Gatter gelegt wird, an dessen beiden anderen Eingängen einmal das Signal anliegt, das angibt, daß die Adressenleitung frei ist und zum anderen das Signal das angibt, daß der Bus frei ist. Erst, wenn alle Signale logisch den gleichen Zustand erreichen, wird das UND-Gatter durchgeschaltet und übermittelt an den Halbleiterspeicher ein Refresh-Signal, so daß aufgrund dieses Refresh-Signales der Halbleiterspeicher sofort seinen Refreshzyklus generiert.

Wurde ein solches Refresh-Signal während der ersten Dauer des Refresh-Wiederholsignals generiert, dann werden die Flip-Flop dieser Steuerschaltung zurückgesetzt und es kann während des Ablaufes der restlichen Periode des Refresh-Wiederholsignales kein neues Refresh-Signal generiert werden.

Konnte aber während des Ablaufes des ersten Teilsignales (Anfang des Refresh-Wiederholsignales) kein entsprechendes Refresh-Signal erzeugt werden, dann wurden auch die entsprechenden Flip-Flops der Steuerschaltung nicht zurückgesetzt und die Steuerschaltung ist nach wie vor in Funktion. Erfindungsgemäss ändert sich dann der logische Zustand des Steuersignales und das Steuersignal wird unter Umgehung der vorgenannten Steuerschaltung unmittelbar auf eine Prioritätssteuereinheit gegeben, wo dann dem Refresh-Signal die dritt- oder viert-höchste Priorität aller im Rechnersystem vorkommenden Prioritäten zugeordnet wird. Versuche und Erfahrungen des Anmelders haben gezeigt, daß die Zuordnung dieser Priorität ausreicht, um während dieses Zeitraumes ein freies Fenster im Rechnerbus zu finden und das Refresh-Signal über diesen Rechnerbus an den Halbleiterspeicher zu übertragen.

Der Erfindungsgegenstand der vorliegenden Erfindung ergibt sich nicht nur aus dem Gegenstand der einzelnen Patentansprüche, sondern auch aus der Kombination der einzelnen Patentansprüche untereinander.

Alle in den Unterlagen offenbarten Angaben und Merkmale, insbesondere die in den Zeichnungen dargestellte, räumliche Ausbildung werden als erfindungswesentlich beansprucht, soweit sie einzeln oder in Kombination gegenüber dem Stand der Technik neu sind.

Im folgenden wird die Erfindung anhand einer lediglich einen Ausführungsweg darstellenden Zeichnung näher erläutert. Hierbei gehen aus der Zeichnung und der Beschreibung weitere erfindungswesentliche Merkmale und Vorteile der Erfindung hervor.

Es zeigen:

Fig. 1 zeigt schematisiert die Anschaltung verschiedener Aggregate an den Rechnerbus;

Fig. 2 zeigt den zeitlichen Verlauf des Refresh-Signals und des Refresh-Wiederholsignals;

Fig. 3 zeigt die Schaltung zur Erzeugung des Refresh-Wiederholsignals;

Fig. 4 zeigt den zeitlichen Verlauf und den logischen Zustand des aus dem Refresh-Wiederholsignal gewonnenen Teilsignals;

Fig. 5 zeigt die Schaltung zur Prioritätensteuerung der beiden aus dem Refresh-Wiederholsignal gewonnenen Teilsignale.

Hinsichtlich der technischen Bezeichnung der in den Schaltbildern verwendeten Bezeichnungen wird darauf hingewiesen, daß z.B. die Bezeichnungen LS 109 oder S 37 oder LSO 2 Bausteine der Firma Texas Instruments bezeichnet, und es sich hier um Typenbezeichnungen dieser Firma handelt.

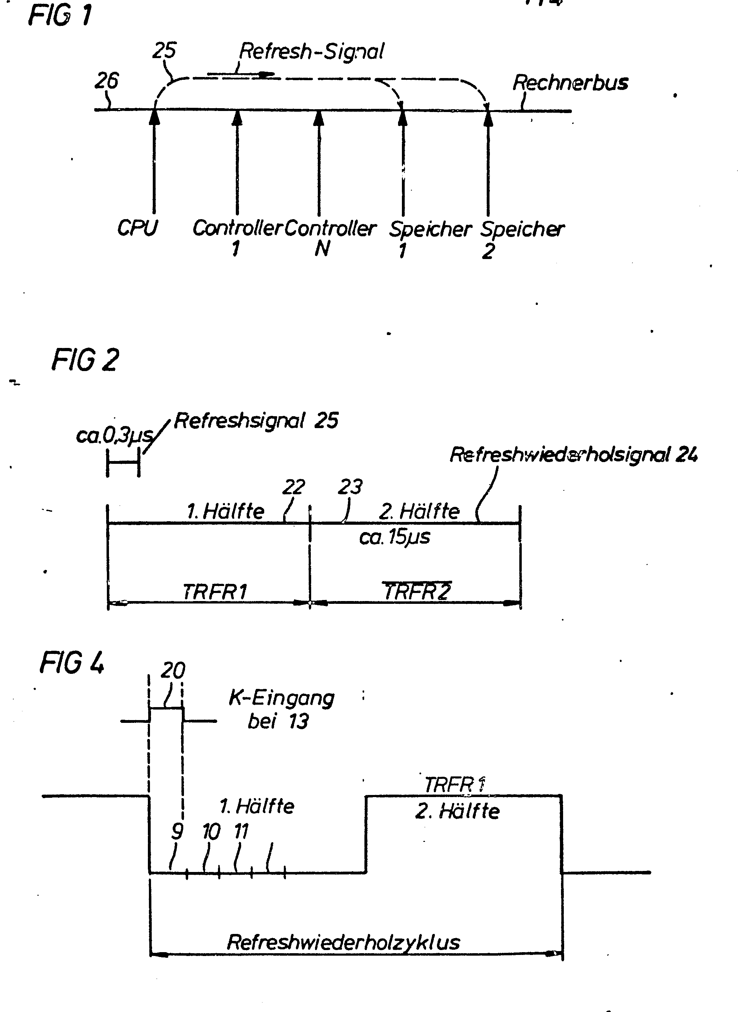

In Figur 1 ist schematisiert gezeigt, daß verschiedene Aggregate des Rechnersystems an den Rechnerbus aufgeschaltet sind. Es sind dies beispielsweise die CPU, verschiedene Controller von externen Geräten, wie b.Z. Plattengerät, Bandspeicher, Bildschirm, Drucker und so weiter. Ferner sind verschiedene Halbleiterspeicher (Speicher 1, Speicher 2) an den Rechnerbus angeschaltet. Es ist ebenso schematisiert dargestellt, daß die CPU zur festgesetzten Zeit ein Refresh- Signal 25 erzeugt, das den Speichern 1 und 2 über den Rechnerbus 26 zugeführt wird.

In Fig. 2 ist ersichtlich, daß das Refresh-Signal 25 im Bereich (während des zeitlichen Ablaufes) des Refresh- Wiederholsignals 24 ablaufen muss. Das Refresh-Wiederholsignal hat etwa eine Länge von 15 Mikrosekunden, während das Refresh-Signal 25 eine Länge von etwa 0,3 Mikrosekunden hat. Erfindungsgemäss ist nun das Refresh-Wiederholsignal 24 in zwei Teilsignale 22, 23 aufgeteilt, von denen das erste, zeitlich zuerst ablaufende Teilsignal die Bezeichnung TRFR1 trägt, während das zweite, nach dem zweiten Teilsignal 22 ablaufende Teilsignal 23 die Bezeichnung $\overline{TRFR2}$ trägt.

Die Aufteilung in zwei gleichlange Teilsignale 22,23 ist willkürlich und wird nur aus schaltungstechnischen Gründen bevorzugt, weil es schaltungstechnisch relativ einfach ist, das Refresh-Wiederholsignal 24 in zwei gleiche Teilsignale 22,23 aufzuteilen. Es ist aber ebenso die Aufteilung mit anderen Aufteilungsverhältnissen, z.B. TRFR1-$\overline{TRFR2}$ wie 1:3 oder 2:3 oder auch 3:2.

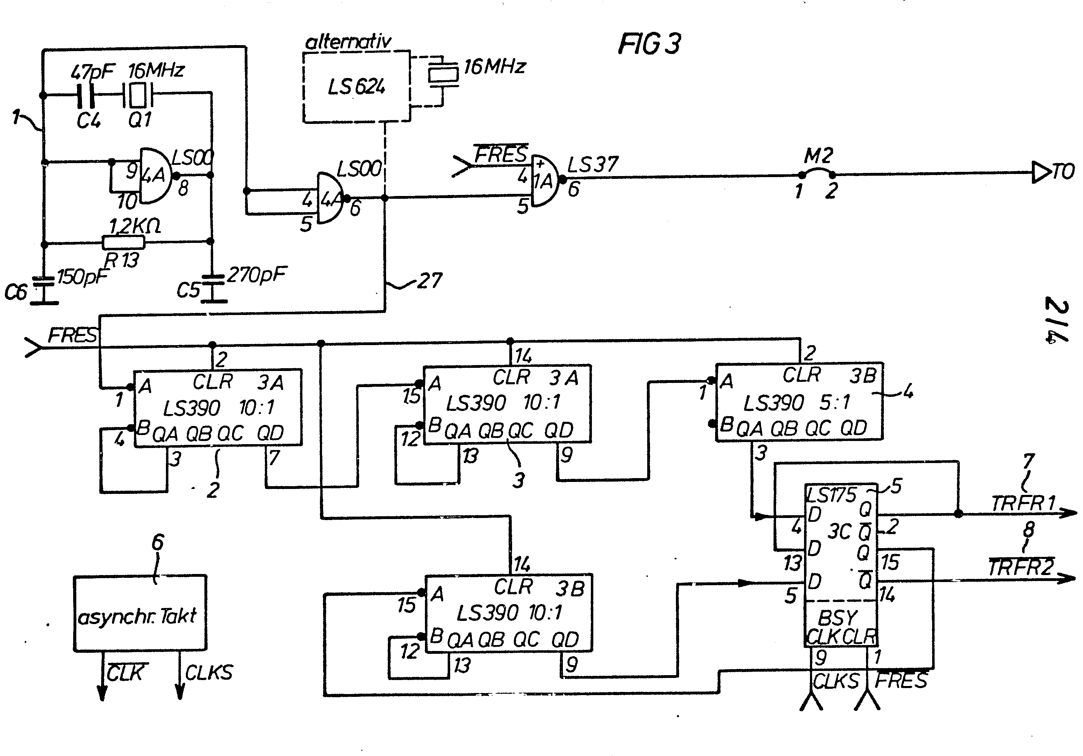

Figur 3 zeigt eine Schaltung zur Generierung der beiden Teilsignale TRFR1 und $\overline{TRFR2}$ aus einem Refresh-Wiederholsignal 24.

Mit einem quarz-stabilen Taktgenerator 1 wird ein Takt erzeugt, der über die Leitung 27 an den Eingang 1 einer Teilerschaltung 2,3,4 gelegt ist. Der so erzeugte Takt wird auf den D-Eingang eines Flip-Flop-5 aufgeschaltet, wo der synchrone Quarztakt in einen asynchronen Rechnertakt einsynchronisiert wird. Hierzu ist eine asynchrone Taktschaltung 6 vorhanden, die einen asynchronen Rechnertakt erzeugt, nämlich entsprechend der Länge eines Speicherzyklus. Über die Leitung CLKS wird dann dieser asynchrone Rechnertakt über den Eingang 9 eingespeist. Am Ausgang 2 des Flip-Flop 5 liegt auf der Leitung 7 das erste Teilsignal TRFR1 des Refresh-Wiederholsignals 24 an. Das zweite Teilsignal 23 liegt am Ausgang 14 an der Leitung 8 des Flip-Flop 5 an und trägt die Bezeichnung $\overline{TRFR}$. Bei dem Flip-Flop 5 handelt es sich um ein D-Flip-Flop, d.h. mit jedem nächsten Takt nimmt der Ausgang den Zustand des Einganges an. Der Ausgang spiegelt also mit einer Zeitverzögerung von einem Takt-Zyklus den Zustand des Einganges wieder.

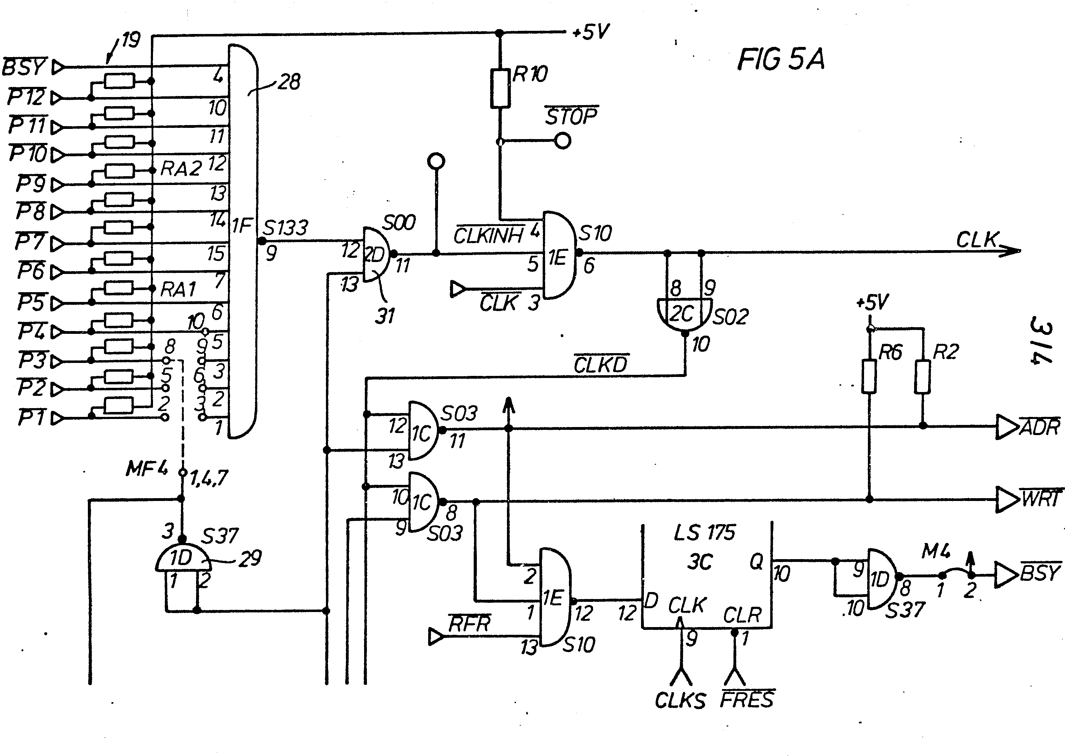

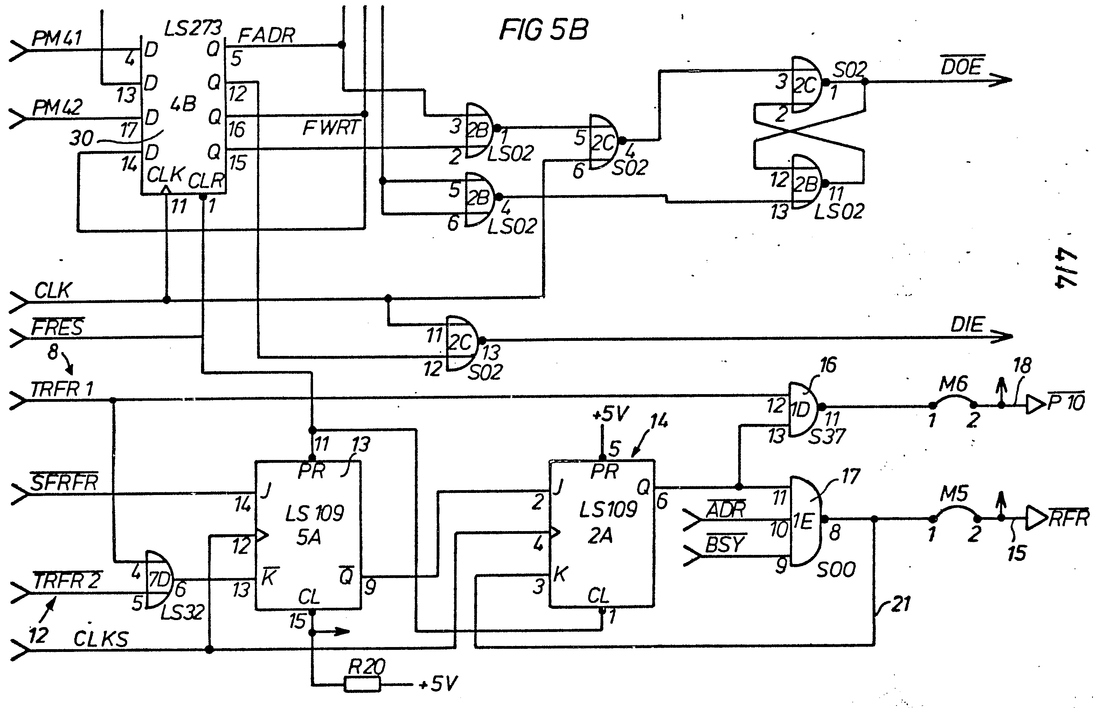

In Figur 4 ist ein solches Ausgangssignal TRFR1 dargestellt, während der Zeitdauer des Refresh-Wiederholsignals ändert sich also das Signal TRFR1 von Digital 0 auf Digital 1. In der ersten Hälfte des TRFR1-Signals laufen eine Reihe von Takten 9,10,11 usw. ab. Die in Fig. 5 gezeigte Steuerschaltung 12 siebt nun einen Takt 20 (das ist das Refresh-Signal 25) während des Refresh-Wiederhol-Zyklus aus. Aus praktischen Gründen wird hierzu die ansteigende Flanke des TRFR1-Signals gewählt; es kann aber auch eine beliebige andere Flanke oder eine andere beliebige Stelle im Laufe des Refresh-Wiederholsignals gewählt werden.

Das Flip-Flop 13 in Figur 5 wird mit Eintreffen der ersten Hälfte des TRFR1-Signals zusammen mit dem Takt 20 auf logisch 1 gesetzt. Der Eingang 13 (K-Eingang) merkt sich also, daß während des Refresh-Wiederholsignals-Zyklus ein Wunsch auf Übergabe eines Refresh-Signals 25 auftritt. Mit Umsetzen dieses Flip-Flops 13 wird auch das nachgeschaltete Flip-Flop eine Taktzahl später eingeschaltet. Der Takt wird über die Leitung CLKS eingespeist.

Nach dem Setzen dieses Flip-Flops 14 auf logisch 1 wird ein Refresh-Signal $\overline{RFR}$ auf der Ausgangsleitung 15 herausgegeben, sofern der Rechnerbus 26 frei ist. Die freie Verfügbarkeit des Rechnerbusses 26 ergibt sich dadurch, daß das am Ausgang 6 des Flip-Flop 14 anstehende Refresh-Signal $\overline{RFR}$ an den Eingang 11 eines UND-Gatters 17 gelegt wird, wobei an den Eingängen 9 und 10 die Signale $\overline{BSY}$ und $\overline{ADR}$ angelegt werden. Das $\overline{ADR}$ ist das Adress-Aufschaltsignal auf den Rechnerbus und hat den Wert logisch 1, wenn der Rechnerbus frei ist.
Der Rechnerbus ist dann frei, wenn das Signal $\overline{BSY}$
auf ebenfalls logisch 1 ist.

Nur wenn alle drei genannten Signale auf logisch 1 sind,
wird das Refresh-Signal $\overline{RFR}$ auf der Leitung 15 in
den Rechnerbus eingegeben, und dem Halbleiterspeicher zugeführt, der sofort einen Refresh-Zyklus geriert. Über die
Leitung 21 wird das Flip-Flop 14 nach Ausgabe eines
Refresh-Signals $\overline{RFR}$ wieder zurückgesetzt, so daß während
des Ablaufes eines Refresh-Wiederhol-Zyklus nur einmal
ein Refresh-Signal ausgegeben werden kann.

Konnte während der ersten Hälfte (logisch O des TRFR1-
Signals) kein Refresh-Signal auf der Leitung 15 ausgegeben werden, dann wurde das Flip-Flop 14 auch nicht
zurückgesetzt und verharrt in seinem Zustand. Nun muß
ein Refresh-Signal mit erhöhter Priorität über den Rechnerbus geschickt werden, damit der Halbleiterspeicher mit
Sicherheit noch während der verbleibenden Dauer des Refresh-
Wiederholsignales sein Refresh-Signal erhält.
Das Zuordnen einer erhöhten Priorität erfolgt folgendermassen:

In der zweiten Hälfte ist das TRFR1-Signal gemäss Fig. 4
logisch 1. Dieses Signal wird unmittelbar auf das UND-Gatter
16 gegeben, an dessen anderen Eingang 13 der Ausgang 6 des
Flip-Flops 14 anliegt, das immer noch eingeschaltet ist,
weil über die Leitung 21 noch kein Rücksetz-Impuls gekommen war. Ferner ist das am Ausgang 14 des Flip-Flop 5 liegende $\overline{TRFR2}$ - Signal logisch 1. Auf der Ausgangsleitung 18
des UND-Gatters 16 wird damit ein Signal $\overline{P\,TO}$ erzeugt,
das jetzt unabhängig davon ist, ob die Adressenleitung
frei ist, oder ob der Rechnerbus 26 belegt ist.

Dieses Signal $\overline{P10}$ wird einer Prioritätssteuereinheit 19 zugeführt, die die Prioritäten der einzelnen, an den Rechnerbus 26 angelegten Aggregate bestimmt. Die Prioritätssteuereinheit 19 besteht aus einem UND-Gatter 28, an dessen Eingängen 13 verschiedene Prioritätssignale aufgeschaltet sind. Das Signal $\overline{P10}$ ist das Prioritätensignal für den Refresh-Zyklus, während das Signal $\overline{BSY}$ das Prioritätensignal für das Bus-System (Bus-Verwaltung) ist.

Wenn das Bus-System in Betrieb ist, setzt es selbst seine Priorität, indem es ein Flip-Flop mit einer Taktzeitverzögerung setzt und dieses Flip-Flop erzeugt, wie in Fig. 5 dargestellt, das Signal $\overline{BSY}$.

Die Eingänge sind ferner mit Widerständen beschaltet und an die positive Versorgungsspannung gelegt, damit vermieden wird, daß bei einem nicht-beschalteten Eingang ein instabiler Zustand entsteht.

Mit einem Stecker MF4 können Prioritäten auf der Schaltplatine der Prioritätssteuereinheit 19 vor Hand gesteckt werden. Im vorliegenden Ausführungsbeispiel haben die unteren zwei Eingänge eine niedrige Priorität und der dritte Eingang wirkt durch seine Beschaltung am Ausgang des UND-Gatters 29 als Ausgang für die darungerliegenden prioritätsniedrigeren Eingänge, d.h. also, je nachdem, wo diese gestrichelt gezeichnete Verbindungslinie vom Ausgang 3 des UND-Gatters 29 auf der Platine gesteckt wird, werden die darunterliegenden Eingänge prioritätsniedriger eingestuft.

Es ist ferner ein Flip-Flop 30 vorhanden, das an seinem Ausgang ein FADR-Signal erzeugt und dieses Flip-Flop steuert das Prioritäten-Gatter (UND-Gatter 29, das an seinem Ausgang 3 das betreffende Prioritätensignal erzeugt).

Das Prioritäten-Signal am Ausgang des Gatters 29 wird nur dann erzeugt und generiert, wenn das betreffende Aggregat sich auf den Rechnerbus aufschalten will, und geprüft werden muss, welche Priorität dieses Aggregat hat und ob es überhaupt auf den Rechnerbus aufgeschaltet werden kann und darf.

Zu diesem Zeitpunkt meldet der Rechner das Prioritäten-Signal über dieses Flip-Flop 9 und die Eingänge PM41 und PM42 an. Das Signal PM42 bedeutet Schreiben , FWRT allgemein, das Signal FADR vom Bit 41 herrührend bedeutet Prioritätenanforderung und wenn nicht Schreiben oder dieses Signal generiert ist, bedeutet es eine Anforderung für Lesen.

Wenn jetzt eine Anforderung für die Einschaltung des Aggregates auf den Rechnerbus kommt, z.B. von der CPU oder von einem der Controller für ein externes Gerät über die Leitung $\overline{P10}$ mit dem Bit PM41, wird das Signal FADR durch das Flip-Flop 9 generiert und das Gatter 29 wird aufgeschaltet und der entsprechende Eingang, an dem das Gatter mit seinem Ausgang angeschlossen ist, wird aktiviert.

Wichtig bei der genannten Prioritätssteuerung ist, daß wenn ein Aggregat seine geforderte Priorität erhalten hat, und sich auf den Rechnerbus aufschalten darf, alle anderen Taktsignale für alle anderen Aggregate abgeschaltet werden, so daß diese Aggregate während der Belegung des Rechnerbusses kein Prioritäten-Anforderungssignal an die Prioritätssteuereinheit 19 richten können.

Die Prioritätssteuereinheit 19 kann jedoch auch in anderer Weise ausgeführt werden. Wichtig ist nur, daß das Prioritä-tensignal $\overline{P10}$ eine so hohe Priorität hat, daß es mit der größten Wahrscheinlichkeit auf den Rechnerbus aufgeschaltet wird, obwohl dessen Priorität unterhalb der Priorität für den Rechnerbus selbst liegt (Signal $\overline{BSY}$) und unterhalb der Prioritäten $\overline{P12}$ und $\overline{P11}$, die beispielsweise externen Controllern von Massenspeichern zugeordnet sind. Entscheidend bei der vorliegenden Erfindung ist nur, daß während der ersten Phase des Refresh-Wiederholsignals versucht wird, mit niedriger Priorität ein Fenster zum Rechnerbus zu finden und - wenn dies nicht gelingt - in der zweiten Phase während des rest_lichen Ablaufes des Refresh-Wiederholsignals mit hoher Priorität dann das Refresh-Signal auf den Rechnerbus gedrückt wird. Es braucht deshalb nicht die höchste Priorität gewählt werden, weil die beiden höchsten Prioritäten entsprechenden Geräten angeordnet sind, die bei Aufschaltung auf den Rechnerbus während der Dauer des "zweiten Fensters" nie die gesamte "Fensterzeit" beanspruchen und deshalb immer noch Zeit für die Aufschaltung des Refreshsignals bleibt.

PATENTANSPRÜCHE
----------------------------------------

1. Verfahren zur Übergabe des Refresh-Signals an einen, an einem zentralen Rechnerbus mit bestimmter Priorität hinsichtlich der Aufschaltung angeschlossenen Halbleiterspeicher, wobei das Refresh-Signal und ein die zeitliche Übergabe des Refresh-Singnals bestimmendes Refresh-Wiederholsignal von einer zentralen Rechnereinheit (CPU) mit bestimmter Priorität im Vergleich zu anderen, am Rechnerbus angeschalteten Aggregaten an den Halbleiterspeicher übergebbar sind, d a d u r c h   g e k e n n z e i c h ne t, daß das Refresh-Wiederholsignal (24) in ein oder mehrere zeitlich aufeinanderfolgende Teilsignale (22,23) aufgeteilt ist und die Übergabe des Refresh-Signals (25) während der Dauer des  ersten Teilsignals (22) mit niedriger Priorität auf den Rechnerbus (26) erfolgt und daß bei nicht möglicher Übergabe des Refresh-Signals (25) während der Dauer des ersten Teilsignals (22) dem Refresh-Signal (25) eine höhere Priorität zugeordnet wird und daß das Refresh-Signal (25) während des Ablaufes des zeitlich hinter dem ersten Teilsignal (22) liegenden, anderen Teilsignal (23) mit höherer Priorität auf den Rechnerbus (26) geschaltet wird.

2. Verfahren nach Anspruch 1, d a d u r c h   g e k e n n z e i c h n e t, daß die während der Dauer des ersten Teilsignals (22) dem Refreshsignal (25) zugeordnete Priorität eine der drei niedrigsten, im Rechneraufbau vorkommende Priorität ist.

3. Verfahren nach Anspruch 1, d a d u r c h   g e k e n n z e i c h n e t, daß die während der Dauer des zweiten Teilsignals (23) dem Refreshsignal (25) zugeordnete höhere Priorität in der Rangfolge unter der Priorität liegt, die den Controllern der externen Massenspeicher (z.B. Platte oder Band) zugeordnet ist.

4. Schaltung zur Ausführung des Verfahrens nach einem der Ansprüche 1 - 3 , d a d u r c h   g e k e n n z e i c h n e t, daß das Refreshwiederholsignal (24) über ein D-Flip-Flop (5) in zwei zeitlich aufeinanderfolgende Teilsignale (22,23) (TRFR1 und $\overline{TRFR2}$) aufgeteilt ist, und daß während der Zeitdauer des ersten Teilsignals TRFR1 (22) eine Steuerschaltung (8,13,14,17) ein Refreshwunschsignal RFR an die CPU dadurch erzeugt, daß das erste Teilsignal TRFR1 (22) am Eingang (Eingang 11) eines UND-Gatters (17) anliegt, an dessen anderen Eingängen (Eingänge 9,10) die Zustandssignale ($\overline{ADR}$ und $\overline{BSY}$) zur Anzeige der Übergabebereitschaft der Adressenleitung und des Rechnerbus (26) anliegen.

5. Schaltung nach Anspruch 4, d a d u r c h   g e k e n n z e i c h n e t, daß während der Zeitdauer des zweiten Teilsignals TRFR2 (23) das erste Teilsignal TRFR1 (22) seinen logischen Zustand wechselt, daß das am Eingang (Eingang 11) des UND-Gatters (17) und am Ausgang eines Flip-Flops (14) anliegende Signal, welches angibt, daß ein Refreshwunsch besteht, das Refreshsignal auf den Rechnerbus auszugeben an den Eingang (Eingang 13) eines weiteren UND-Gatters (16) gelegt ist, an dessen anderen Eingang (Eingang 12) ebenfalls das erste Teilsignal TRFR1 (22) entsprechend der zweiten Hälfte des Refreshwiederholsignals (24) anliegt, und daß das am Ausgang (Ausgang 11) des UND-Gatters (16) erzeugte Signal ($\overline{P10}$) als Prioritätssignal hoher Rangstufe einer Prioritätssteuerschaltung (19) zur Aufschaltung auf den Rechnerbus (26) zuge- führt ist.

FIG 1

25    Refresh-Signal

26                                    Rechnerbus

CPU    Controller  Controller   Speicher  Speicher
          1           N            1         2

FIG 2

ca.0,3μs  Refreshsignal 25

                                    Refreshwiederholsignal 24

              22    23
1. Hälfte          2. Hälfte
                    ca. 15μs

TRFR1              TRFR2

FIG 4

      20
              K-Eingang
                bei 13

                              TRFR 1
              1. Hälfte        2. Hälfte
      9   10  11

          Refreshwiederholzyklus

H 600

FIG 3

0073969

0073969

FIG 5A

314

FIG 5B

414

0073969